# FASCICULE DE BREVET EUROPEEN

(11) **EP 0 533 606 B1**
(45) Date de publication et mention de la délivrance du brevet: **01.02.1995**
(21) Numéro de dépôt: 92470024.8
(22) Date de dépôt: 11.09.1992
(51) Int. Cl.: B05D 7/24, B05D 7/14, C23C 16/54

(54) **Procédé et dispositif de revêtement d'un produit métallurgique par des couches de polymères, et produit obtenu par ce procédé**
Verfahren und Vorrichtung zur Beschichtung von metallurgischen Gegenständen mit Polymerschichten und daraus hergestelltes Produkt
Method and apparatus for coating a metallurgical substrate with polymeric layers and product so obtained

(30) Priorité: 18.09.1991 FR 9111670
(43) Date de publication de la demande: 24.03.1993
(73) Titulaire: SOLLAC S.A., 92800 Puteaux (FR)
(72) Inventeur: Schuster, Frédéric, F-78100 Saint Germain en Laye (FR); Mongrelet, Thierry, F-78780 Maurecourt (FR); Segui, Yvan, F-31280 Mons (FR); Barreau, Corinne, F-78100 Saint Germain en Laye (FR); Lecuyer, Carole, F-78100 Saint Germain en Laye (FR)
(74) Mandataire: Ventavoli, Roger

(56) Documents cités:
- EP-A- 0 229 522
- US-A- 4 650 700
- US-A- 4 701 354
- US-A- 4 803 947
- US-A- 4 981 713
- IBM TECHNICAL DISCLOSURE BULLETIN vol. 17, no. 12, Mai 1975, NEW YORK,USA page 3718 K.L. MITTALL 'vapor deposited adhesion promoters'

## Description

L'invention concerne le revêtement des produits métallurgiques, notamment des tôles d'acier, en vue de leur appliquer ultérieurement une couche de peinture.

Actuellement, les tôles d'acier que l'on désire enduire d'une couche de peinture, dans un but décoratif et/ou de protection contre la corrosion, doivent subir un traitement comportant les étapes suivantes, réalisées en continu si la tôle est conditionnée en bobines. La tôle, qui selon les cas est nue ou déjà revêtue d'une couche de zinc (galvanisée), subit tout d'abord une préparation de sa surface. Cette préparation comporte une phase de nettoyage, puis une phase de conversion chimique superficielle. Cette dernière phase consiste en une phosphatation, c'est-à-dire la formation d'un phosphate de fer amorphe en surface, lorsque la tôle est nue, ou en une chromatation lorsque la tôle est une tôle galvanisée. Cette phase de conversion chimique a pour but de permettre l'accrochage de la couche organique dite "primaire de peinture" qui est déposée lors de l'étape suivante. Le primaire est le plus souvent une résine époxy ou vinylique, et est déposé par une vernisseuse en une couche d'épaisseur 15 à 50 »m environ. Le produit passe ensuite dans un four de cuisson et l'épaisseur de la couche de primaire sèche passe à 5 »m environ. Une deuxième vernisseuse applique ensuite la couche de peinture, dont l'épaisseur est variable selon les usages du produit et le type de peinture utilisé. Cette couche est enfin séchée dans un deuxième four.

En ce qui concerne les produits qui sont à revêtir à l'unité (tôles déjà découpées, pièces de formes diverses) des opérations similaires sont effectuées de manière discontinue.

Le grand nombre d'opérations unitaires que l'on vient de citer rend complexes et coûteuses les installations sur lesquelles ces traitements sont appliqués. Les étapes de cuisson suivant les vernissages sont, de plus, grosses consommatrices d'énergie.

Le but de l'invention est de simplifier le processus de mise en peinture des produits sidérurgiques tout en diminuant sa consommation d'énergie.

A cet effet, l'invention a pour objet un procédé de revêtement d'un produit métallurgique, notamment sidérurgique, selon lequel on forme sur la surface dudit produit une première couche d'un premier polymère organique protégeant ledit produit contre la corrosion, tel qu'un polysilane ou un polysiloxane, par exposition de ladite surface à un plasma basse température dans une atmosphère de traitement contenant à l'état gazeux le monomère dudit premier polymère, caractérisé en ce qu'on forme, sur ladite première couche, une deuxième couche d'un deuxième polymère présentant une bonne mouillabilité de surface, par exposition de la surface du produit à un plasma dans une atmosphère contenant à l'état gazeux le monomère dudit deuxième polymère.

L'invention a également pour objets des dispositifs, tels que définis par la revendication 4, pour la mise en oeuvre de ce procédé, et les produits, tels que définis par la revendication 5, ainsi obtenus.

Comme on l'aura compris, le procédé consiste à exécuter tout d'abord, de manière connue, le revêtement du produit au moyen d'un plasma basse température par un polymère tel qu'un polysiloxane ou un polysilane, pour améliorer son aspect de surface et sa résistance à la corrosion ou à l'abrasion. On effectue ensuite, de la même façon, le dépôt sur cette première couche de polymère d'une deuxième couche de polymère. Celle-ci a la particularité de présenter une bonne mouillabilité et de rendre ainsi possible le dépôt ultérieur d'une couche de peinture qui aura de bonnes propriétés d'accrochage sur le produit. Le polyacrylonitrile constitue un exemple d'un tel polymère.

L'invention sera mieux comprise au vu de la description qui suit, faisant référence aux figures annexées suivantes :
- la figure 1 schématise vue en coupe un exemple d'installation selon l'invention, permettant le traitement à l'unité de tôles métalliques ;
- la figure 2 schématise une installation permettant le traitement en continu de tôles métalliques en bobines ;
- la figure 3 schématise une variante de l'installation de la figure 2.

Parmi les polymères pouvant être ainsi déposés, on peut citer le polystyrène, celui-ci étant utilisé pour protéger le métal de base contre la corrosion (voir, par exemple, le document JP 02104669). Des polymères d'alcanes et d'alcanes halogénés sont également déposés pour augmenter la dureté superficielle du métal de base (voir le document JP 61190526). Les polysilanes et polysiloxanes s'avèrent être des polymères particulièrement intéressants pour divers usages. En effet, leurs liaisons Si-C sont réputées pour la dureté qu'elles conférent au polymère, et leurs liaisons Si-O sont intéressantes pour la protection contre la corrosion (voir le document US 4981713, dont les caractéristiques correspondent au préambule des revendications 1 et 5 annexées). On pourrait donc penser à les employer pour la protection superficielle de matériaux métalliques destinés à être ensuite enduits de peinture, par exemple pour des tôles d'acier nues ou galvanisées destinées à l'industrie automobile, ou des profilés destinés au bâtiment. Malheureusement, les polysilanes et polysiloxanes ne présentent qu'une médiocre mouillabilité, et il n'est pas envisageable d'y déposer une peinture dans de bonnes conditions.

La solution retenue par les inventeurs consiste à effectuer sur le produit métallique un dépôt par plasma basse température de polysiloxane ou de polysilane (ou de tout autre polymère présentant des avantages et inconvénients similaires), et d'effectuer ensuite par le même procédé le dépôt d'une couche d'un deuxième polymère présentant, lui, des propriétés hydrophiles, ainsi qu'une bonne adhérence sur le premier dépôt. Le polyacrylonitrile est un exemple de polymère présentant de telles caractéristiques favorables.

Le dépôt de polymères organiques sur des matériaux métalliques au moyen de techniques utilisant un plasma froid selon le préambule de la revendication 1 est aujourd'hui bien connu, par exemple par le document US 4981713. Le principe en est le suivant. Deux électrodes sont disposées dans une enceinte étanche, et dans l'espace compris entre ces électrodes, on place le produit à revêtir, qui peut également constituer luimême l'une des électrodes ou en être solidaire. On fait le vide dans l'enceinte, puis on y introduit à l'état gazeux le monomère du polymère que l'on désire déposer sur le produit, tout en maintenant la pression totale dans l'enceinte à une valeur de l'ordre de 0,1 à 1000 Pa. Puis on établit entre les électrodes un courant alternatif en basse fréquence (de l'ordre de 2500 à 50000 Hz) ou en radiofréquence (classiquement 13,56 MHz). Il en résulte la formation dans l'enceinte, et particulièrement entre les électrodes, d'un plasma basse température (désigné ainsi par opposition aux plasmas de fusion thermonucléaire ou "plasmas chauds"), celle-ci étant de l'ordre de 20 à 700° C environ. Sous l'effet du plasma, par des réactions chimiques dont les mécanismes ne sont pas encore complètement élucidés, a lieu le dépôt sur le produit métallurgique d'une couche de polymère du monomère introduit dans l'enceinte. L'épaisseur de cette couche croit de manière régulière avec le temps, jusqu'à atteindre des valeurs de quelques centaines à quelques milliers d'Å.

Des résultats similaires peuvent être obtenus en imposant une tension continue entre les deux électrodes (procédé dit "cathode sputtering"). La pièce à recouvrir peut alors être placée en anode.

Dans le même temps, la première couche de polymère continue à jouer son rôle de protection vis-à-vis de la corrosion, rôle pour lequel un revêtement formé d'une couche unique de polymère hydrophile serait beaucoup moins efficace.

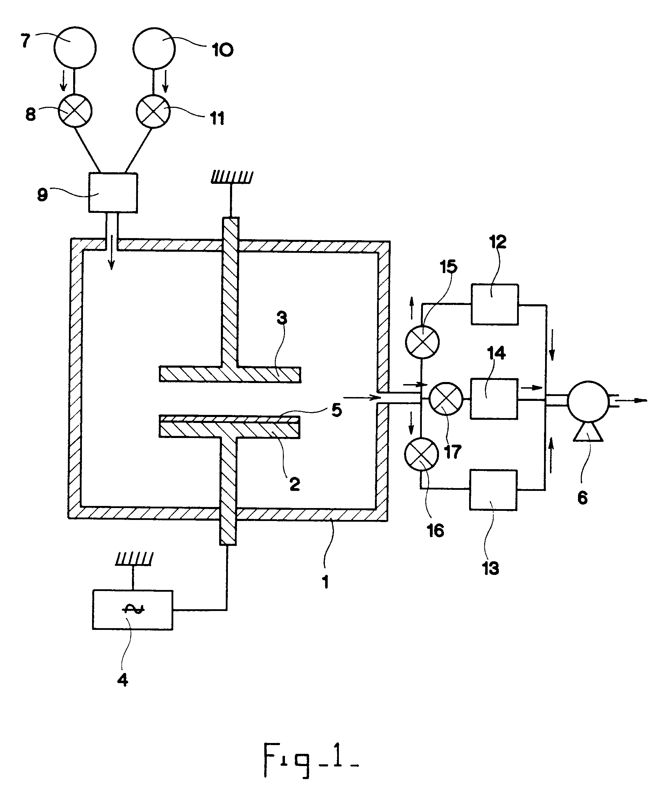

La figure 1 représente schématiquement une installation adaptée au traitement qui vient d'être décrit.

L'enceinte étanche 1 est équipée de deux électrodes 2, 3. L'électrode 2 est reliée à un générateur de courant alternatif 4, alors que l'électrode 3 est reliée à la terre. La partie électrique de l'installation comprend également des moyens non représentés de mesure et de contrôle des paramètres électriques, du type de ceux habituellement rencontrés sur les installations de traitement par plasma basse température fonctionnant en courant alternatif. On peut ainsi régler la tension entre les électrodes et l'intensité du courant qui les traverse. La tôle métallique 5 à revêtir est placée sur l'électrode 2 et expose sa surface à revêtir à l'atmosphère de l'enceinte. Cette atmosphère est contrôlée au moyen d'une pompe 6 permettant de maintenir la pression totale dans l'enceinte 1 dans la gamme 0,1-1000 Pa, et d'une installation permettant l'injection de monomère gazeux dans l'enceinte. Cette installation comprend un réservoir 7 renfermant le monomère du polymère destiné à former la première couche sur la tôle 5. Ce monomère est par exemple, un siloxane, tel que l'hexaméthyldisiloxane, et se trouve dans des conditions de température et de pression telles qu'il peut s'échapper du réservoir 7 à l'état gazeux. Son débit est contrôlé par une vanne 8.

Avant de pénétrer dans l'enceinte 1, le gaz passe par une chambre de mélange 9. L'installation comprend de même un deuxième réservoir 10 contenant le monomère du polymère destiné à former la couche hydrophile sur la tôle 5. Ce monomère peut être, par exemple, de l'acrylonitrile, et se trouve lui aussi au moins partiellement à l'état gazeux dans le réservoir 10. La vanne 11 permet de contrôler son débit de sortie, avant sa pénétration dans la chambre de mélange 9, puis dans l'enceinte 1. L'installation est, bien entendu, également pourvue de tous les moyens non représentés connus et nécessaires pour la mesure des débits respectifs des monomères.

L'installation est utilisée comme suit. le vide est d'abord fait dans l'enceinte grâce à la pompe 6 jusqu'à une pression de l'ordre de 1 Pa. Puis le premier monomère est introduit dans l'enceinte à partir du réservoir 7 par ouverture de la vanne 8. Lorsque sa pression partielle s'est stabilisée au niveau désiré, on met en route le processus de formation du plasma en appliquant une différence de potentiel alternative entre les électrodes 2 et 3, ce qui a pour effet de provoquer le dépôt de la première couche de polymère sur la tôle 5. L'opération est poursuivie autant de temps que nécessaire pour obtenir sur la tôle 5 un dépôt de l'épaisseur désirée. le monomère gazeux non utilisé est aspiré hors de l'enceinte 1 par la pompe 6. Il pénètre alors dans un piège à azote liquide 12 qui le condense et permet sa récupération. Lorsque l'épaisseur désirée de la première couche est atteinte, la vanne 8 est fermée et la vanne 10 ouverte : on fait ainsi pénétrer dans l'enceinte 1 le deuxième monomère à partir du réservoir 10. Ce monomère une fois polymérisé va former sur la tôle la couche de polymère hydrophile. Le monomère non utilisé est de même aspiré et envoyé dans un deuxième piège à azote liquide 13. Pendant la brève période transitoire lors de laquelle les deux monomères peuvent coexister dans l'enceinte 1, les gaz s'échappant de l'enceinte sont envoyés dans un troisième piège à azote liquide 14 où les monomères se condensent tous deux. Cela permet de ne recueillir dans les autres pièges 12, 13 que des monomères à l'état pur. Le mélange recueilli dans le troisième piège subit ensuite un traitement de séparation et les monomères peuvent être ensuite réutilisés. L'orientation vers les différents pièges des gaz s'échappant de l'enceinte 1 est déterminée par les vannes en tout ou rien 15, 16, 17. Il est également possible d'arrêter complètement l'opération entre les phases de dépôt des deux couches, ce qui évite la période transitoire de coexistence des monomères, et rend inutile le troisième piège 14.

La méthode d'utilisation précédente conduit à la formation d'une interface franche entre les deux polymères. Il y a alors un risque d'une adhérence insuffisante des deux couches l'une sur l'autre si leurs natures respectives sont mal accordées. Pour améliorer cette adhérence, on peut créer une "interface diffuse" entre ces couches, en procédant de la manière suivante. En fin de formation de la première couche, on diminue le débit du premier monomère par fermeture progressive de la vanne 8, tout en ouvrant graduellement la vanne 11, qui commande l'admission du deuxième monomère dans l'enceinte 1. La chambre 9 permet de mélanger les deux monomères avant leur entrée dans l'enceinte 1. Pendant le temps d'ouverture simultanée des deux vannes 8 et 11, les deux polymères se déposent sur la tôle 5 dans des proportions dépendant des débits respectifs des monomères, la proportion du deuxième polymère dans le mélange augmentant progressivement. On crée ainsi une zone, dite "interface diffuse", dans laquelle les deux polymères sont intimement mêlés, la proportion du deuxième polymère dans le mélange augmentant au fur et à mesure qu'on se rapproche de la surface libre du dépôt. Pendant cette période, les gaz s'échappant de l'enceinte 1 sont envoyés dans le piège 14 où, comme on l'a vu précédemment, les deux monomères sont condensés. Après fermeture totale de la vanne 8, le polymère hydrophile se dépose seul, comme dans le mode d'utilisation précédent, jusqu'à obtention de l'épaisseur désirée.

Le dispositif qui vient d'être décrit s'applique au traitement de pièces unitaires, telles que des tôles déjà découpées, qui sont ainsi revêtues sur une seule de leurs faces. Si on désire que les deux faces de la tôle soient revêtues de polymère, il faut alors placer la tôle entre les électrodes et non au contact de l'une d'elles. De cette façon, les deux faces peuvent être ensuite peintes avec une bonne adhérence de la peinture. On pourra également choisir de ne peindre qu'une seule des faces revêtues de polymères, le revêtement de l'autre face étant laissé nu et ne jouant qu'un rôle de protection, par exemple contre la corrosion.

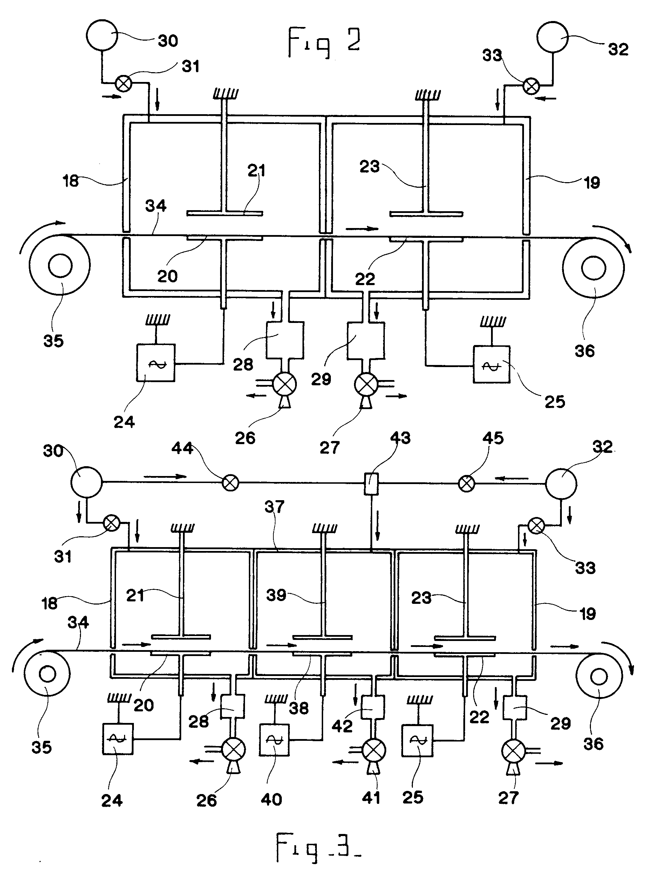

On peut également désirer revêtir en continu des tôles en défilement conditionnées sous forme de bobines. La figure 2 schématise une installation adaptée à un tel traitement, analogue dans son architecture générale à celle décrite dans le document US 4803947 qui présente un dispositif du type comprenant deux enceintes séparées l'une de l'autre de manière étanche, équipées chacune de moyens de production d'un plasma basse température, la première enceinte étant pourvue de moyens d'introduction à l'état gazeux du monomère d'un premier polymère et la deuxième enceinte étant pourvue de moyens d'introduction à l'état gazeux du monomère d'un deuxième polymère, oú des moyens sont prévus pour faire défiler en continu le produit à revêtir successivement à l'intérieur desdites enceintes.

Elle est composée de deux enceintes accolées 18, 19 comprenant chacune un couple d'électrodes 20, 21 et 22, 23 reliées à des générateurs de courant alternatif 24, 25. Ces enceintes 18,19 sont chacune reliées à une pompe 26, 27 permettant la régulation de leurs pressions intérieures entre 0,1 et 1000 Pa environ, et à des pièges à azote liquide 28, 29. L'enceinte 18 est reliée à un réservoir 30 contenant le premier monomère et muni d'une vanne 31, et l'enceinte 19 est reliée à un réservoir 32 contenant le deuxième monomère et muni d'une vanne 33. La tôle à revêtir 34, préalablement conditionnée sous forme d'une bobine 35, est mise en défilement par des moyens classiques non représentés, et traverse successivement les deux enceintes 18, 19 avant de s'enrouler sous forme d'une bobine 36 après sa sortie de l'enceinte 19. Des moyens sont prévus pour garantir l'étanchéité des enceintes 18 et 19 entre elles et vis-à-vis de l'extérieur aux points d'entrée et de sortie de la tôle 34. Des moyens non représentés sont également prévus pour garantir le contact entre la tôle 34 et les électrodes 20 et 22. Comme précédemment, on peut aussi choisir de revêtir les deux faces de la tôle 34 en la faisant défiler entre les électrodes et non au contact de l'une d'entre elles. Une autre façon de réaliser ce revêtement des deux faces consiste à prévoir dans chaque enceinte un deuxième couple d'électrodes agissant de manière symétrique au premier. L'enceinte 18 est le siège du dépôt de la couche du premier polymère (par exemple de polysilane ou de polysiloxane), et l'enceinte 19 est le siège du dépôt du polymère hydrophile (tel que du polyacrylonitrile). Dans ce cas, la séparation entre les deux couches est franche. On peut également éloigner les enceintes l'une de l'autre pour éviter d'éventuels problèmes d'étanchéité entre elles. Une telle disposition aurait cependant l'inconvénient d'exposer à l'air libre la surface du premier polymère, ce qui entraîne un risque de pollution préjudiciable à la bonne adhérence de la couche de polymère hydrophile.

Bien entendu, la tôle 34 en défilement peut subir d'autres traitements avant et après son passage dans les enceintes 18 et 19. Celles-ci sont tout à fait intégrables, par exemple, à une ligne de vernissage qui comporterait, en amont des enceintes 18 et 19, une installation de nettoyage de la tôle 34, et en aval une vernisseuse et ses annexes habituelles (four, refroidisseur, sécheur) pour l'application de la couche de peinture. Le dispositif selon l'invention se substituerait à l'installation de phosphatation ou de chromatation et à la vernisseuse déposant le primaire de peinture, qui sont présentes ainsi que leurs annexes sur les lignes de vernissage classiques.

Si, dans une telle installation, on désire créer entre les deux couches de polymère une interface qui se rapproche de l'interface diffuse dont il a été précédemment question, on peut, selon la revendication 4, ajouter une enceinte supplémentaire à l'installation de la figure 2, comme représenté sur la figure 3. Dans cette enceinte supplémentaire est réalisé le dépôt d'une couche comportant simultanément les deux polymères. Sur la figure 3, les organes communs avec la figure 2 sont repérés par les mêmes références. L'enceinte supplémentaire 37 est insérée entre les enceintes 18 et 19. Comme elles, elle est munie d'électrodes 38, 39 reliées à un générateur de courant alternatif 40, la tôle 34 en défilement étant au contact de l'électrode 38. Une pompe 41 assure le maintien dans l'enceinte 37 de la pression désirée, et son circuit comprend un piège à azote liquide 42. L'enceinte 37 est alimentée en monomères par une chambre de mélange 43 reliée aux deux réservoirs 30 et 32 contenant les monomères dont les vannes 44 et 45 permettent de régler les proportions respectives dans le mélange (par exemple 50-50% en masse). Celui-ci parvient dans l'enceinte 37 et est déposé sous forme polymérisée sur la surface de la tôle 34 qui a été préalablement revêtue par le premier polymère dans l'enceinte 18. On crée ainsi une couche mixte sur laquelle le polymère hydrophile déposé ensuite dans l'enceinte 19 adhérera mieux que sur une couche pure du premier polymère. Bien entendu, il est possible de multiplier le nombre d'enceintes insérées entre les enceintes 18 et 19, de manière à créer plusieurs couches mixtes dont la teneur en polymère hydrophile irait croissant. On se rapproche ainsi encore davantage de l'interface diffuse que l'on peut créer lors d'un traitement discontinu dans une enceinte unique, comme décrit précédemment.

Dans tous ces dispositifs, l'épaisseur des différentes couches peut être réglée en jouant sur les temps de traitement (c'est-à-dire les temps de séjour dans les diverses enceintes, pour les dispositifs de traitement en continu) et les paramètres électriques de l'installation. A titre d'exemple, une tôle destinée à être peinte peut être revêtue successivement d'une couche de 500 Å à 2 »m de polysiloxane ou de polysilane et de 100 Å de polyacrylonitrile, avec une interface diffuse de 100 A. Comme on le voit, une très mince couche de polymère hydrophile est suffisante pour permettre un bon accrochage ultérieur de la peinture.

Des variantes aux installations précédemment décrites peuvent être imaginées dans le cadre des revendications annexées. Par exemple les plasmas peuvent être générés par des courants continus établis entre les électrodes. Dans le cas de l'utilisation d'un courant alternatif, la tôle à revêtir peut être mise au contact de l'électrode reliée à la terre. De même on peut traiter non seulement des tôles, mais des matériaux de formes diverses, par exemple des profilés destinés au bâtiment, qu'il est de plus en plus courant de peindre. Dans ce cas, il faut s'assurer que la répartition des dépôts de polymère s'effectue de façon homogène sur tout le produit, par exemple en prévoyant des moyens pour réaliser une diffusion égale du plasma dans toute la zone de présence du produit, ou en donnant aux électrodes des formes qui épousent celles du produit.

L'invention s'applique à tous les cas ou on désire obtenir, pour un produit métallique protégé par un polymère, par exemple contre la corrosion ou l'usure, une surface extérieure présentant de bonnes propriétés de mouillabilité.

## Revendications

1. Procédé de revêtement d'un produit métallurgique, notamment sidérurgique, selon lequel on forme sur la surface dudit produit une première couche d'un premier polymère organique, tel qu'un polysilane ou un polysiloxane, par exposition de ladite surface à un plasma basse température dans une atmosphère de traitement contenant à l'état gazeux le monomère dudit premier polymère, caractérisé en ce qu'on forme sur ladite première couche, une deuxième couche d'un deuxième polymère présentant une bonne mouillabilité de surface, également par exposition de la surface à un plasma dans une atmosphère contenant à l'état gazeux le monomère dudit deuxième polymère.

2. Procédé selon la revendication 1, caractérisé en ce que ledit deuxième polymère est du polyacrylonitrile.

3. Procédé selon la revendication 1 ou 2, caractérisé en ce qu'on réalise la formation de ladite deuxième couche de polymère en introduisant dans l'atmosphère de traitement contenant initialement le monomère du seul premier polymère, une proportion croissante du monomère dudit second polymère, et en ce qu'on termine l'opération en n'introduisant plus dans ladite atmosphère de traitement que le monomère du seul deuxième polymère.

4. Dispositif pour la mise en oeuvre du procédé selon la revendication 3, du type comprenant deux enceintes (18,19) séparées l'une de l'autre de manière étanche, équipées chacune de moyens (20,21,22,23,24,25) de production d'un plasma basse température, la première enceinte (18) étant pourvue de moyens (30,31) d'introduction à l'état gazeux du monomère dudit premier polymère et la deuxième enceinte (19) étant pourvue de moyens (32,33) d'introduction à l'état gazeux du monomère dudit deuxième polymère, des moyens étant prévus pour faire défiler en continu le produit (34) à revêtir successivement à l'intérieur desdites enceintes (18,19), tel que comprenant, disposée entre lesdites enceintes (18,19) sur le parcours dudit produit (34), au moins une enceinte supplémentaire (37) séparée desdites enceintes (18,19) de manière étanche, pourvue de moyens (38,39,40) de production d'un plasma basse température, de moyens (43,44,45) d'introduction simultanée dans ladite enceinte desdits monomères, et de moyens pour régler les quantités relatives desdits monomères.

5. Produit métallurgique revêtu d'une couche d'un premier polymère le protégeant contre la corrosion, tel qu'un polysilane ou un polysiloxane, déposée par traitement superficiel par plasma basse température, caractérisé en ce que ladite couche de polymère est revêtue d'une couche d'un deuxième polymère présentant des propriétés de mouillabilité, déposée par traitement superficiel par plasma basse température.

6. Produit métallurgigue selon la revendication 5, caractérisé en ce que ledit deuxième polymère est du polyacrylonitrile.

7. Produit métallurgique selon la revendication 5 ou 6, caractérisé en ce que l'interface entre lesdites couches de polymère est une interface diffuse, et en ce que la proportion du premier polymère dans ladite interface diminue au fur et à mesure que l'on se rapproche de la surface libre du produit.

8. Application du procédé selon l'une des revendications 1 à 3, caractérisée en ce qu'il est appliqué au revêtement de produits métallurgiques destinés à être revêtus d'une couche de peinture.

## Claims

1. Method of coating a metallurgical product, especially a ferrometallurgical product, according to which a first layer of a first organic polymer, such as a polysilane or a polysiloxane, is formed on the surface of the said product by exposing the said surface to a low-temperature plasma in a treatment atmosphere containing, in the gaseous state, the monomer of the said first polymer, characterized in that a second layer of a second polymer exhibiting good surface wettability is formed on the said first layer, likewise by exposing the surface to a plasma in an atmosphere containing, in the gaseous state, the monomer of the said second polymer.

2. Method according to Claim 1, characterized in that the said second polymer is polyacrylonitrile.

3. Method according to Claim 1 or 2, characterized in that the formation of the said second layer of polymer is produced by introducing an increasing proportion of the monomer of the said second polymer into the treatment atmosphere initially containing the monomer of just the first polymer and in that the operation is terminated by introducing only the monomer of just the second polymer into the said treatment atmosphere.

4. Device for the implementation of the method according to Claim 3, of the type comprising two chambers (18, 19) separated from each other in a sealed manner, each equipped with means (20, 21, 22, 23, 24, 25) for producing a low-temperature plasma, the first chamber (18) being provided with means (30, 31) for introducing, in the gaseous state, the monomer of the said first polymer and the second chamber (19) being provided with means (32, 33) for introducing, in the gaseous state, the monomer of the said second polymer, means being provided for continuously progressing the product (34) to be coated successively inside the said chambers (18, 19), such as comprising, arranged between the said chambers (18, 19) in the path of the said product (34), at least one additional chamber (37) separated from the said chambers (18, 19) in a sealed manner, provided with means (38, 39, 40) for producing a low-temperature plasma, means (43, 44, 45) for simultaneously introducing the said monomers into the said chamber, and with means for regulating the relative quantities of the said monomers.

5. Metallurgical product coated with a layer of a first polymer protecting it from corrosion, such as a polysilane or a polysiloxane, deposited by low-temperature plasma surface treatment, characterized in that the said layer of polymer is coated with a layer of a second polymer exhibiting wetting properties, this layer being deposited by low-temperature plasma surface treatment.

6. Metallurgical product according to Claim 5, characterized in that the said second polymer is polyacrylonitrile.

7. Metallurgical product according to Claim 5 or 6, characterized in that the interface between the said layers of polymer is a diffuse interface and in that the proportion of the first polymer in the said interface progressively decreases on moving towards the free surface of the product.

8. Application of the method according to one of Claims 1 to 3, characterized in that it is applied to the coating of metallurgical products intended to be coated with a layer of paint.

## Patentansprüche

1. Verfahren zur Beschichtung eines metallurgischen, insbesondere stahlmetallurgischen, Produktes, bei dem man an der Oberfläche des Produktes eine erste Schicht eines ersten organischen Polymers, wie eines Polysilans oder eines Polysiloxans, bildet indem die Oberfläche einem Plasma niedriger Temperatur in einer Behandlungsatmosphäre ausgesetzt wird, die das Monomer des ersten Polymers in gasförmigem Zustande enthält, dadurch gekennzeichnet, daß man auf der ersten Schicht eine zweite Schicht eines zweiten Polymers bildet, das eine gute Benetzbarkeit der Oberfläche aufweist, indem die Oberfläche ebenfalls einem Plasma in einer Atmosphäre ausgesetzt wird, die das Monomer des zweiten Polymers in gasförmigem Zustande enthält.

2. Verfahren nach Anspruch 1, dadurch gekennzeichnet, daß das zweite Polymer Polyacrylnitril ist.

3. Verfahren nach Anspruch 1 oder 2, dadurch gekennzeichnet, daß man die Bildung der zweiten Polymerschicht durch Einführen in eine Behandlungsatmosphäre durchführt, die anfänglich das Monomer nur des ersten Polymers, einen sich steigernden Anteil des Monomers des zweiten Polymers enthält, und daß man den Vorgang beendet, indem man in die Behandlungsatmosphäre nur mehr das Monomer des zweiten Polymers einführt.

4. Vorrichtung zur Durchfuhrung des Verfahrens nach Anspruch 3, jener Art, die zwei voneinander abgedichtet getrennte Räume (18,19) aufweist, von denen ein jeder mit Einrichtungen (20,21,22,23,24,25) zum Erzeugen eines Plasmas niedriger Temperatur versehen ist und von denen der erste Raum (18) mit Einrichtungen (30,31) zum Einfuhren des Monomers des ersten Polymers in gasförmigem Zustande und der zweite Raum (19) mit Einrichtungen (32,33) zum Einführen des Monomers des zweiten Polymers in gasförmigem Zustande ausgestattet ist, wobei Einrichtungen zum fortlaufenden und aufeinanderfolgenden Hindurchführen des zu beschichtenden Produktes durch das Innere der Räume (18,19) vorgesehen sind, und die so ausgebildet ist, daß sie wenigstens einen zusätzlichen, an der Bahn des Produktes (34) zwischen den genannten Räumen (18,19) gelegenen, von diesen Räumen (18,19) abgedichtet getrennten Raum aufweist, der mit Einrichtungen (38,39,40) zum Erzeugen eines Plasmas niedriger Temperatur, mit Einrichtungen (43,44,45) zur gleichzeitigen Einführung der Monomere in diesen Raum und mit Einrichtungen zum Regulieren der relativen Mengen der Monomere versehen ist.

5. Metallurgisches Produkt, das mit einer durch eine Oberflächenbehandlung mittels eines Plasmas niedriger Temperatur abgelagerten Schicht eines ersten, ihn gegen Korrosion schützenden Polymers, wie einem Polysilan oder einem Polysiloxan, bedeckt ist, dadurch gekennzeichnet, daß diese Polymerschicht von einer Schicht eines zweiten Polymers bedeckt ist, das Benetzbarkeitseigenschaften aufweist, und die durch eine Oberflächenbehandlung mittels eines Plasmas niedriger Temperatur abgelagert ist.

6. Metallurgisches Produkt nach Anspruch 5, dadurch gekennzeichnet, daß das zweite Polymer Polyacrylnitril ist.

7. Metallurgisches Produkt nach Anspruch 5 oder 6, dadurch gekennzeichnet, daß die Grenzschicht zwischen den genannten Polymerschichten eine diffuse Grenzschicht ist, und daß der Anteil des ersten Polymers in der Grenzschicht in dem Maße abnimmt, in dem man sich der freien Oberfläche des Produktes nähert.

8. Anwendung des Verfahrens nach einem der Ansprüche 1 bis 3, dadurch gekennzeichnet, daß es auf die Beschichtung von metallurgischen Produkten angewendet wird, die zur Beschichtung mit einer Schicht eines Farbauftrages bestimmt sind.
